(19) **Europäisches Patentamt European Patent Office Office européen des brevets**

(11) **EP 3 535 778 B1**

(12) **FASCICULE DE BREVET EUROPEEN**

(45) Date de publication et mention de la délivrance du brevet:
**15.03.2023 Bulletin 2023/11**

(21) Numéro de dépôt: **17800912.2**

(22) Date de dépôt: **03.11.2017**

(51) Classification Internationale des Brevets (IPC):
**H01L 21/58** (2006.01)   **B05D 5/08** (2006.01)
**B82Y 30/00** (2011.01)

(52) Classification Coopérative des Brevets (CPC):
(C-Sets disponibles)
**H01L 24/83; H01L 24/29; H01L 24/95;** B82Y 30/00;
H01L 2224/29186; H01L 2224/83002;
H01L 2224/83026; H01L 2224/83051;
H01L 2224/83143; H01L 2224/83192;
H01L 2224/83203; H01L 2224/83896;
H01L 2224/95146; H01L 2924/14         (Cont.)

(86) Numéro de dépôt international:
**PCT/FR2017/053014**

(87) Numéro de publication internationale:
**WO 2018/083425 (11.05.2018 Gazette 2018/19)**

(54) **PROCEDE DE FABRICATION DE PLOTS D'ASSEMBLAGE SUR UN SUPPORT POUR L'AUTO-ASSEMBLAGE D'UN CIRCUIT ELECTRONIQUE SUR LE SUPPORT**

VERFAHREN ZUR HERSTELLUNG VON MONTAGEKISSEN AUF EINEM TRÄGER ZUR SELBSTMONTAGE EINER ELEKTRONISCHEN SCHALTUNG AUF DEM TRÄGER

PROCESS FOR MANUFACTURING ASSEMBLY PADS ON A CARRIER FOR THE SELF-ASSEMBLY OF AN ELECTRONIC CIRCUIT ON THE CARRIER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.11.2016 FR 1660626**

(43) Date de publication de la demande:
**11.09.2019 Bulletin 2019/37**

(73) Titulaire: **Commissariat à l'Energie Atomique et aux Energies Alternatives**
**75015 Paris (FR)**

(72) Inventeurs:
• **DI CIOCCIO, Léa**
  **38330 Saint Ismier (FR)**
• **BERTHIER, Jean**
  **38240 Meylan (FR)**
• **POSSEME, Nicolas**
  **38360 Sassenage (FR)**

(74) Mandataire: **Cabinet Beaumont**
**4, Place Robert Schuman**
**B.P. 1529**
**38025 Grenoble Cedex 1 (FR)**

(56) Documents cités:
**WO-A1-2016/112344     JP-A- 2001 087 953**
**US-A1- 2014 238 645     US-A1- 2014 360 252**
**US-A1- 2015 287 695**

• **YANG HE ET AL: "Superhydrophobic silicon surfaces with micronano hierarchical structuresdeep reactive ion etching and galvanic etching", ANALYTICAL SCIENCES, THE JAPAN SOCIETY FOR ANALYTICAL CHEMISTRY, US, vol. 364, no. 1, 9 juillet 2011 (2011-07-09), pages 219-229, XP028390257, ISSN: 0021-9797, DOI: 10.1016/J.JCIS.2011.07.030 [extrait le 2011-08-05]**

• **RICHARD WILLIAMS ET AL: "Wetting of thin layers of SiO 2 by water", APPLIED PHYSICS LETTERS, vol. 25, no. 10, 15 novembre 1974 (1974-11-15), pages 531-532, XP055393880, US ISSN: 0003-6951, DOI: 10.1063/1.1655297**

(52) Classification Coopérative des Brevets (CPC): (Cont.)

C-Sets
H01L 2224/29186, H01L 2924/05442

**Description**

<u>Domaine</u>

La présente invention concerne un procédé de fabrication de plots sur un support pour la mise en oeuvre d'un procédé d'auto-assemblage d'un circuit électronique sur le support.

<u>Exposé de l'art antérieur</u>

Pour certaines applications, un circuit électronique ou plusieurs circuits électroniques, par exemple des circuits intégrés, sont fixés à un support. Le support correspond, par exemple, à un autre circuit intégré. La fixation peut être réalisée par collage moléculaire ou par thermocompression.

Avant de fixer le circuit intégré au support, il est nécessaire de placer correctement le circuit intégré par rapport au support. Ceci peut être réalisé par un procédé d'auto-assemblage du circuit intégré sur le support.

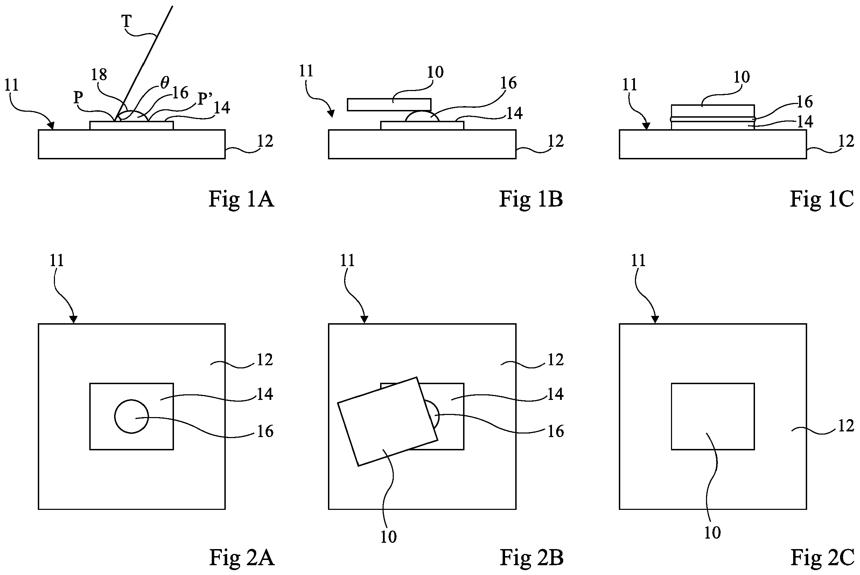

Les figures 1A à 1C sont des vues en coupe, partielles et schématiques, de structures obtenues à des étapes successives d'un exemple de procédé d'auto-assemblage d'un circuit électronique 10, par exemple un circuit intégré, sur un support 11, et les figures 2A à 2C sont des vues de dessus respectivement des structures représentées aux figures 1A à 1C.

Le support 11 comprend un substrat 12 en un matériau à faible mouillabilité, par exemple du silicium, et comprend, en surface du substrat 12, un plot 14 d'un matériau à forte mouillabilité. Le support 11 peut comprendre plusieurs plots 14. Une goutte 16 d'un liquide, par exemple de l'eau déminéralisée, est disposée sur le plot 14 (figures 1A et 2A). Le plot 14 peut être réalisé en formant une couche d'oxyde de silicium sur le substrat 12 et en gravant la couche obtenue pour délimiter le plot 14. La couche d'oxyde de silicium peut avoir une épaisseur de l'ordre de 50 nm.

De façon générale, la mouillabilité d'un matériau peut être caractérisée par l'angle de contact $\theta$ d'une goutte de liquide sur le matériau. Plus l'angle de contact est faible, plus la mouillabilité du matériau est élevée. Dans le plan de coupe de la figure 1A, l'interface 18 liquide/air de la goutte 16 est en contact avec le plot 14 aux points de contact P et P'. On appelle T la tangente à l'interface 18 au point de contact P (ou P'). L'angle de contact $\theta$ de la goutte 16 sur le plot 14 est l'angle entre la tangente T et la surface du plot 14, la surface du plot 14 étant horizontale. Lorsque la goutte 16 est au repos, l'angle $\theta$ mesuré est l'angle de contact statique.

Le circuit électronique 10 est alors approché du plot 14 jusqu'à venir au contact de la goutte 16. Dans cette phase d'approche, le circuit électronique 10 peut être décalé et incliné par rapport au plot 14 (figures 1B et 2B).

Les forces exercées par la goutte 16 sur le circuit électronique 10 déplacent alors le circuit électronique 10 jusqu'à l'alignement souhaité par rapport au plot 14 (figures 1C et 2C) sans qu'aucune action extérieure ne soit nécessaire.

Le procédé de fixation du circuit électronique 10 au support 11, par exemple par collage moléculaire ou par thermocompression, peut alors être mis en oeuvre.

Pour que le procédé d'auto-assemblage se déroule convenablement, il est nécessaire que la goutte 16 reste confinée sur le plot 14 tout au long de l'alignement du circuit électronique 10 par rapport au support 11. Dans l'exemple de procédé d'auto-assemblage décrit précédemment, le confinement de la goutte 16 sur le plot 14 tout au long du procédé d'auto-assemblage est obtenu par la différence de mouillabilité entre le plot 14 et le substrat 12. Plus la différence de mouillabilité est élevée, plus la goutte 16 tend à rester confinée sur le plot 14.

Toutefois, avec les procédés connus, il peut être difficile d'obtenir une différence de mouillabilité importante entre le plot 14 et le substrat 12. Il peut alors se produire des erreurs de placement de la goutte 16 sur le support 11 et la goutte 16 peut quitter le plot 14 au cours du procédé d'auto-assemblage.

Il existe donc un besoin de réalisation de plots pour l'auto-assemblage permettant d'améliorer le confinement de gouttes de liquide sur un support pour la mise en oeuvre d'un procédé d'auto-assemblage.

Il est, en outre, souhaitable que le procédé de fabrication des plots soit compatible avec les techniques classiques de fabrication de circuits électroniques.

Le document US 2014/360252 décrit un procédé de fabrication d'un substrat comprenant des motifs pour la mise en oeuvre d'un procédé d'auto-assemblage. Le document WO 2016/112344 décrit un dispositif de caractérisation d'entités cellulaires. Le document US 2014/238645 décrit un dispositif de transfert de chaleur. Le document US 2015/287695 décrit un support destiné à la mise en oeuvre d'un procédé d'auto-assemblage. Le document JP 2001/087953 décrit un procédé d'auto-assemblage. La publication de Yang et al intitulée "Superhydrophobic silicon surfaces with micronano hierarchical structures deep reacive ion etching and galvanic etching" décrit un procédé de fabrication de surface superhydrophobe.

<u>Résumé</u>

Un objet de l'invention est de pallier tout ou partie des inconvénients des supports connus comprenant des plots pour la mise en oeuvre d'un procédé d'auto-assemblage et des procédés connus de fabrication de tels plots.

Un autre objet de la présente invention est d'améliorer le confinement de gouttes de liquide sur des plots d'un support pour la mise en oeuvre d'un procédé d'auto-assemblage.

Un autre objet de la présente invention est d'augmenter la différence de mouillabilité entre chaque plot et le substrat entourant le plot.

Un autre objet de la présente invention est que le procédé de fabrication des plots soit compatible avec les procédés classiques de fabrication de circuits électroniques.

Ainsi, un mode de réalisation prévoit un procédé selon la revendication 1 d'auto-assemblage d'un élément sur une face d'un support, comprenant les étapes suivantes :

fournir un support comprenant au moins un plot d'assemblage sur ladite face ;

déposer une goutte d'un liquide sur le plot d'assemblage ; et

amener l'élément au contact de la goutte, d'où il résulte un auto-assemblage de l'élément par rapport au support, le support comprenant des poteaux nanométriques ou micrométriques sur ladite face autour du plot, chaque poteau comprenant au moins un coeur en silicium amorphe ou polycristallin, la goutte de liquide ayant un angle de contact statique sur le plot d'assemblage inférieur ou égal à 15, la goutte de liquide ayant un angle de contact statique sur les poteaux supérieur ou égal à 150°.

Selon un mode de réalisation, les poteaux ont une hauteur H et une largeur a mesurée dans un plan parallèle à la face, des poteaux adjacents étant écartés d'un écart b mesuré dans un plan parallèle à la face. La hauteur H, la largeur a et l'écart b vérifient les relations suivantes :

$$a < \frac{b}{4}$$

$$H \geq b$$

$$b < \sqrt{\frac{\Gamma}{\rho\,g}}$$

où $\Gamma$ est égal à la tension de surface du liquide, $\rho$ est égal à la densité du liquide et g est la constante gravitationnelle.

Selon un mode de réalisation, chaque poteau comprend au moins en surface un matériau fluoré.

Selon un mode de réalisation, le matériau fluoré est un matériau fluorocarboné.

Selon un mode de réalisation, le support comprend, en outre, une protubérance comprenant des flancs et un sommet, le plot d'assemblage étant sur le sommet.

Selon un mode de réalisation, les flancs comprennent en surface le matériau fluoré.

Selon un mode de réalisation, le procédé de fabrication comprend la formation, sur le support, de poteaux nanométriques ou micrométriques autour de l'emplacement du plot d'assemblage, une goutte de liquide ayant un angle de contact statique sur le plot d'assemblage inférieur ou égal à 15°, la goutte de liquide ayant un angle de contact statique sur les poteaux supérieur ou égal à 150°.

Selon un mode de réalisation, le procédé comprend le dépôt d'une couche de silicium amorphe ou polycristallin sur la face et la gravure de la couche de silicium amorphe ou polycristallin pour former les poteaux.

Selon un mode de réalisation, le procédé comprend le dépôt d'une couche poreuse sur la couche de silicium amorphe ou polycristallin.

Selon un mode de réalisation, l'étape de formation des poteaux comprend la formation en surface de chaque poteau d'une couche d'au moins un matériau fluoré.

Selon un mode de réalisation, le procédé comprend l'exposition des poteaux et de l'emplacement à un traitement ultraviolet en présence d'ozone pour former le plot d'assemblage audit emplacement.

Selon un mode de réalisation, l'élément est une puce de circuit électronique.

Selon un mode de réalisation, le procédé comprend, en outre, les étapes suivantes :

faire sécher la goutte ; et

fixer l'élément au support.

## Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figures 1A à 1C, décrites précédemment, sont des vues en coupe de structures obtenues à des étapes successives d'un exemple de procédé d'auto-assemblage ;
les figures 2A à 2C, décrites précédemment, sont des vues de dessus respectivement des figures 1A à 1C ;
les figures 3 et 4 sont des vues en coupe de modes de réalisation d'un support comprenant un plot destiné à la mise en oeuvre d'un procédé d'auto-assemblage ;
la figure 5 est une vue de détail de la figure 3 selon un autre mode de réalisation du support ;
la figure 6 est une vue de détail de la figure 3 représentant une goutte de liquide reposant sur le support en dehors du plot d'assemblage ;
les figures 7 et 8 sont des vues de détail, respectivement de dessus et de côté, de la figure 3 ;
les figures 9A à 9E sont des vues en coupe, partielles et schématiques, de structures obtenues à des étapes successives d'un mode de réalisation d'un procédé de fabrication du support représenté en figure 3 ;
les figures 10A et 10B sont des vues en coupe, partielles et schématiques, de structures obtenues à des étapes successives d'un mode de réalisation d'un procédé d'auto-assemblage mettant en oeuvre le support de la figure 3 ; et
les figures 11A et 11B sont des vues en coupe, partielles et schématiques, de structures obtenues à des étapes successives d'un mode de réalisation d'un procédé de fabrication du support représenté en figure 4 et d'un procédé d'auto-assemblage mettant en oeuvre le support de la figure 4.

## Description détaillée

De mêmes éléments ont été désignés par de mêmes références dans les différentes figures. Par souci de clarté, seuls les éléments utiles à la compréhension des modes de réalisation décrits ont été représentés et sont détaillés. Sauf précision contraire, les expressions "approximativement", "sensiblement", et "de l'ordre de" signifient à 10 % près, de préférence à 5 % près.

Dans la suite de la description, on appelle "matériau hydrophile" un matériau dont l'angle de contact statique d'une goutte de liquide sur le matériau est inférieur à 90° et "matériau hydrophobe" un matériau dont l'angle de contact statique d'une goutte de liquide sur le matériau est supérieur à 90°.

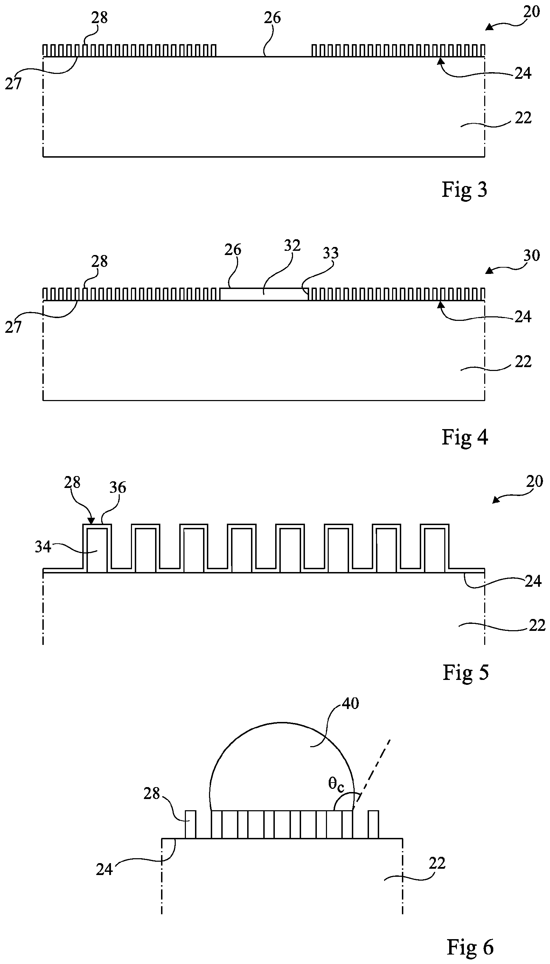

La figure 3 est une vue en coupe d'un mode de réalisation d'un support 20 sur lequel un circuit électronique, non représenté, est destiné à être fixé par un procédé d'auto-assemblage.

Le support 20 comprend un substrat 22 ayant une face 24, de préférence sensiblement plane, et un plot 26 destiné à la mise en oeuvre d'un procédé d'auto-assemblage. Dans le présent mode de réalisation, le plot 26 correspond à une portion de la face 24. Le support 20 peut comprendre plusieurs plots 26. Le support 20 comprend, en outre, des poteaux micrométriques ou nanométriques 28 disposés sur une région 27 de la face 24 autour du plot 26.

Selon l'invention, le plot 26 présente une mouillabilité élevée, l'angle de contact statique d'une goutte de liquide sur le plot 26 étant inférieur ou égal à 15°, de préférence inférieur ou égal à 10°, plus préférentiellement inférieur ou égal à 5°. Comme cela sera décrit plus en détail par la suite, la présence des poteaux 28 et leur préparation hydrophobe confèrent une mouillabilité faible au support 20 pour la partie du support 20 entourant le plot 26, l'angle de contact statique d'une goutte de liquide sur le support 20 pour la partie du support 20 entourant le plot 26, étant supérieur ou égal à 110°, de préférence supérieur ou égal à 130°, plus préférentiellement supérieur ou égal à 150°.

La mesure de l'angle de mouillage peut être réalisée en utilisant l'appareil de mesure commercialisé par la société GBX sous l'appellation Digidrop - MCAT. La mesure comprend le dépôt d'une goutte d'eau déminéralisée de 2 à 10 $\mu$l sur une surface du matériau à étudier, l'acquisition d'une image de la goutte par un dispositif d'acquisition d'images et la détermination de l'angle de contact par une analyse par ordinateur de l'image acquise.

La figure 4 est une vue en coupe d'un autre mode de réalisation d'un support 30. Le support 30 comprend l'ensemble des éléments du support 20 à la différence que le plot 26 est réalisé au sommet d'un élément en saillie 32, également appelé protubérance, par rapport à la face 24. De façon avantageuse, le plot 26 peut alors être situé à la même hauteur que le sommet des poteaux 28. La hauteur de l'élément en saillie 32 peut être comprise entre quelques micromètres et une centaine de micromètres, typiquement entre 5 um et 50 um. De préférence, la hauteur de l'élément en saillie est sensiblement égale à la hauteur des poteaux 28. L'élément en saillie 32 comprend des flancs 33 sensiblement perpendiculaires à la face 24. A titre de variante, les flancs 33 peuvent être inclinés par rapport à la face 24 d'un angle compris entre 10° et 90°, de préférence entre 45° et 90°.

La figure 5 est une vue de détail d'un autre mode de réalisation du support 20 ou 30 dans lequel chaque poteau 28 comprend un coeur 34 recouvert d'une couche 36 d'un matériau hydrophobe. La couche hydrophobe 36 peut également s'étendre sur la face 24 du substrat 22 à l'exception du plot 26. A titre de variante, les poteaux 28 peuvent être en totalité réalisés dans le matériau hydrophobe.

Selon un mode de réalisation, le matériau hydrophobe est un matériau fluoré, de préférence fluorocarboné. A titre d'exemple, la couche hydrophobe 36 est à base de composés fluorocarbonés de type $C_xF_y$, où x et y sont des nombres réels, x pouvant varier de 1 à 5 et y pouvant varier de 1 à 8. L'épaisseur de la couche hydrophobe 36 est, par exemple, comprise entre 10 nm et 300 nm.

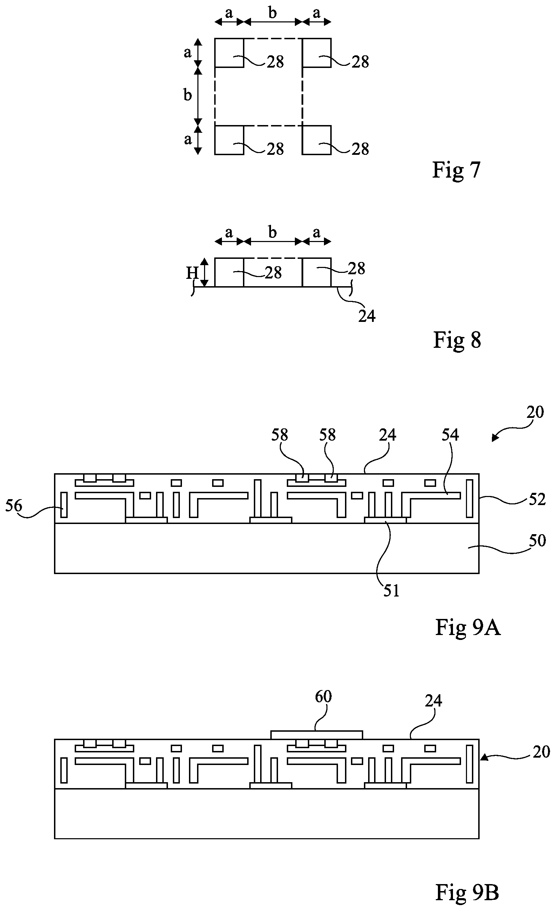

La figure 6 est une vue de détail de la figure 3 représentant une goutte de liquide 40 reposant sur les poteaux 28 et les figures 7 et 8 illustrent des paramètres dimensionnels des poteaux 28. On va maintenant décrire trois paramètres dimensionnels d'un poteau 28, sachant que ces paramètres peuvent être identiques ou différents d'un poteau à l'autre.

On appelle hauteur H la hauteur du poteau 28. De préférence, les poteaux 28 ont sensiblement la même hauteur H.

La section droite de chaque poteau 28 dans un plan parallèle à la face 24 peut être sensiblement circulaire, ellipsoïdale ou polygonale, par exemple triangulaire, carrée ou rectangulaire. A titre de variante, la section droite de chaque poteau 28 dans un plan parallèle à la face 24 peut avoir une forme quelconque. Dans la suite de la description, on appelle largeur a la plus petite dimension de la section droite du poteau 28 dans un plan parallèle à la face 24. A titre d'exemple, lorsque le poteau 28 a une section droite circulaire dans un plan parallèle à la face 24, la distance a peut correspondre au diamètre de la section droite et lorsque le poteau 28 a une section droite carrée dans un plan parallèle à la face 24, la distance a peut correspondre au côté de la section droite. Le poteau 28 peut avoir une forme généralement cylindrique, la section droite du poteau 28 ne variant sensiblement pas en fonction de la distance à la face 24. A titre de variante, la section droite du poteau 28 peut varier en fonction de la distance à la face 24. A titre d'exemple, le poteau 28 peut avoir une forme généralement conique ou tronconique.

On appelle écart b la distance séparant deux poteaux 28 adjacents mesurée dans un plan parallèle à la face 24. L'écart b entre deux poteaux 28 peut sensiblement ne pas varier en fonction de la distance à la face 24. C'est notamment le cas lorsque les poteaux 28 ont une forme généralement cylindrique. A titre de variante, l'écart b entre deux poteaux 28 adjacents peut varier en fonction de la distance à la face 24. C'est notamment le cas lorsque les poteaux 28 ont une forme générale conique ou tronconique. Les poteaux 28 sont de façon avantageuse répartis de façon sensiblement régulière sur la face 24 en dehors du plot 26.

Les dimensions des poteaux 28 sont choisies de façon que la goutte de liquide 40 repose sensiblement sur les sommets des poteaux 28. En particulier, la hauteur H est suffisamment élevée et l'écart b est suffisamment faible pour qu'une goutte de liquide déposée sur les poteaux 40 ne "s'empale" pas sur les poteaux 28 et ne vienne pas au contact de la face 24. Ceci est obtenu lorsque la hauteur H et l'écart b respectent les relations (1) suivantes :

$$H \geq b$$
$$b < \sqrt{(\Gamma/(\rho\,g))} \qquad\qquad (1)$$

où $\sqrt{(\Gamma/(\rho\,g))}$ correspond à la longueur capillaire, c'est-à-dire le rayon d'une goutte du liquide considéré pour laquelle l'énergie de tension de surface est égale à l'énergie de potentielle de pesanteur, avec $\Gamma$ égal à la tension de surface du liquide considéré exprimée en N/m, $\rho$ égal à la densité du liquide considéré exprimée en kg/m$^3$ et g la constante gravitationnelle.

Lorsque la goutte de liquide 40 repose sensiblement sur les sommets des poteaux 28, l'angle de contact statique $\theta_C$ de la goutte de liquide 40 qui est mesuré est supérieur à l'angle de contact statique $\theta$ que l'on obtient lorsque la goutte de liquide est disposée sur une surface plane composée du même matériau que le matériau à la surface des poteaux 28.

Il existe plusieurs lois, appelées lois de Cassie ou lois de Cassie-Baxter, qui relient les angles de contact statiques $\theta_C$ et $\theta$ et qui dépendent notamment de la surface relative des plots 28. A titre d'exemple, pour des poteaux 28 ayant des sommets plats, les angles de contact statiques $\theta_C$ et $\theta$ sont reliés par la relation (2) suivante :

$$\cos\theta_C = -1 + f(1 + \cos\theta) \qquad\qquad (2)$$

où f est le rapport, en vue de dessus, entre la surface occupée par les poteaux 28 au contact de la goutte 40 et l'aire de la base de la goutte 40.

Dans le cas où les poteaux 48 sont cylindriques à base carrée, comme cela est représenté à titre d'exemple sur les figures 7 et 8, les angles de contact statiques $\theta_C$ et $\theta$ sont reliés par la relation (3) suivante :

$$\cos\theta_C = -1 + \frac{a^2}{(a+b)^2}(1+\cos\theta) \tag{3}$$

Dans le cas où le sommet des poteaux 48 a une forme hémisphérique, les angles de contact statiques $\theta_C$ et $\theta$ sont reliés par la relation (4) suivante :

$$\cos\theta_C = -1 + f(1+\cos\theta)^2 \tag{4}$$

De plus, dans le cas où les poteaux ont en surface un matériau rugueux, on définit la rugosité r de ce matériau comme le rapport entre la surface réelle du matériau par rapport à la surface apparente du matériau, la surface apparente étant la surface créée par la projection de la surface réelle sur un plan. Dans le cas où la rugosité r est supérieure à l'unité, l'angle de contact statique $\theta$ dans les relations indiquées précédemment est remplacé par l'angle de contact statique $\theta^*$ donné par la relation de Wenzel (5) suivante :

$$\cos\theta^* = r\cos\theta \tag{5}$$

Un angle de contact statique $\theta_C$ superhydrophobique, c'est-à-dire supérieur à 180°, est obtenu dès que les dimensions a et b vérifient la relation (6) suivante :

$$a < \frac{b}{4} \tag{6}$$

Selon un exemple, la largeur a peut être égale à 250 nm, l'écart b peut être égal à 1 um et la hauteur H peut être supérieure ou égale à 1 um. Selon un autre exemple, la largeur a peut être égale à 20 nm, l'écart b peut être égal à 80 nm et la hauteur H peut être supérieure ou égale à 80 nm.

Les figures 9A à 9E sont des vues en coupe, partielles et schématiques, de structures obtenues à des étapes successives d'un mode de réalisation d'un procédé de fabrication du support 20 représenté en figure 3. Sur les figures 9A à 9E, un seul plot 26 est représenté. Il est clair que le présent mode de réalisation du procédé de fabrication peut être mis en oeuvre pour réaliser simultanément plusieurs plots 26.

La figure 9A représente le support 20. Sur les figures 9A à 9E, on a représenté le support 20 sous la forme d'un circuit électronique comprenant un substrat semiconducteur 50 dans lequel et sur lequel sont réalisés des composants électroniques 51, le substrat 50 étant recouvert d'un empilement 52 de couches isolantes entre lesquelles sont formées des pistes conductrices électriquement 54 et au travers desquelles sont formés des vias conducteurs électriquement 56. La face 24 du support 20 correspond par exemple à la surface libre d'une couche en un matériau isolant électriquement, par exemple en oxyde de silicium. Des éléments conducteurs électriquement 58 peuvent affleurer sur la face 24.

La figure 9B représente la structure obtenue après le dépôt d'une portion 60 d'une résine photosensible sur la face 24. A titre d'exemple, l'épaisseur de la portion de résine 60 peut être comprise entre 500 nm et 3 um, par exemple de l'ordre de 2,5 um. La couche d'oxyde de silicium qui délimite la face 24 facilite notamment l'accrochage de la résine. Le dépôt de la portion de résine 60 peut être réalisé par des étapes classiques de photolithographie comprenant :

le dépôt d'une couche de résine sur la totalité de la face 24 ;
l'exposition de la couche de résine à un rayonnement au travers d'un masque pour reproduire dans la couche de résine des motifs du masque définissant le contour de la portion 60 ; et
la dissolution d'une partie de la couche de résine pour délimiter la portion 60.

La résine peut être une résine photosensible "positive". La partie de la résine exposée au rayonnement devient alors soluble dans une solution aqueuse ou organique spécifique, appelée solution de développement, et la partie de la résine non exposée reste insoluble dans la solution de développement. La résine peut être une résine photosensible "négative". La partie de la résine exposée au rayonnement devient alors insoluble dans la solution de développement et la partie de la résine non exposée reste soluble dans la solution de développement.

Des exemples de résine comprennent les composés suivants :

phénolformaldéhyde, par exemple un mélange de diazo-naphtoquinone (ou DNQ) et d'une résine novolaque (résine de phénolformaldéhyde) ;
polyhydroxystyrène ;
poly(méthyl méthacrylate) ou PMMA ;
poly(méthyl glutarimide) ou PMGI ; et
polymère à base époxy (par exemple résine commercialisée sous l'appellation SU-8 par la société Microchem) .

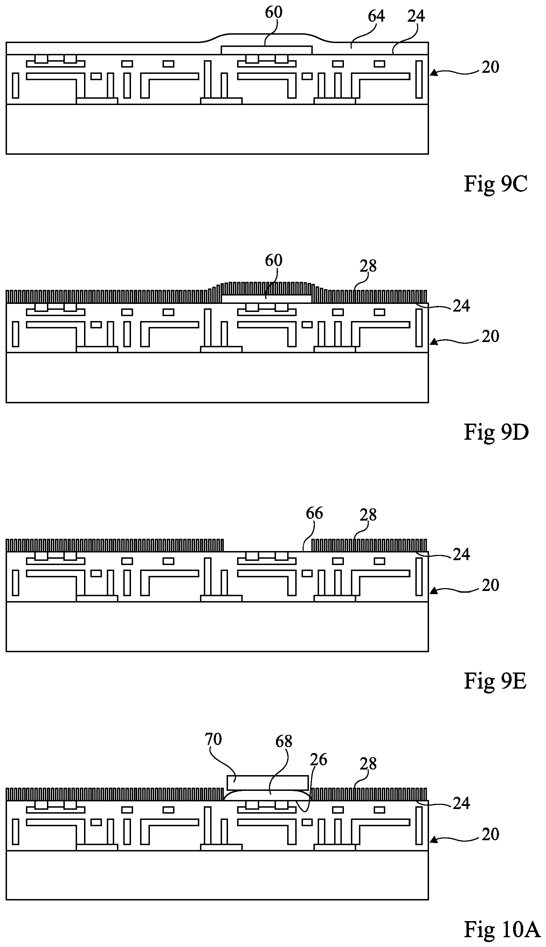

La figure 9C représente la structure obtenue après le dépôt d'une couche 64 de silicium amorphe ou polycristallin. De façon avantageuse, le dépôt est réalisé à une température compatible avec la résine, par exemple à une température inférieure à 300°C. La couche 64 peut être déposée par des procédés de dépôt en phase vapeur ou PVD (sigle anglais pour Physical Vapor Déposition). De préférence, l'épaisseur de la couche 64 est sensiblement égale à la hauteur H souhaitée pour les poteaux 28.

La figure 9D représente la structure obtenue après la formation des poteaux 28 dans la couche 64. Les poteaux 28 peuvent être obtenus par la mise en oeuvre de procédés analogues à ceux utilisés pour l'obtention de silicium noir (en anglais black silicon) à partir d'une couche de silicium monocristallin.

Ceci peut être obtenu par gravure de la couche 64 dans des conditions de gravure qui entraînent la formation des poteaux 28. Selon un mode de réalisation, la gravure est réalisée dans un réacteur de gravure, par exemple un réacteur à plasma à couplage inductif ou ICP (sigle anglais pour Inductively Coupled Plasma). La gravure peut être une gravure par ions réactifs ou RIE (sigle anglais pour Reactive Ion Etching). La gravure peut être réalisée en utilisant un gaz de gravure fluoré, par exemple de l'hexafluorure de soufre ($SF_6$) ou du trifluorure d'azote ($NF_3$), et un gaz oxydant, par exemple du dioxygène ($O_2$). Un gaz de dilution, par exemple de l'argon (Ar), de l'hélium (He) ou du bromure d'hydrogène (HBr) peut être prévu. Le rapport F/O entre le gaz de gravure fluoré et le gaz oxydant est choisi pour obtenir la formation des poteaux 28 avec les dimensions souhaitées. La température dans le réacteur de gravure est de préférence inférieure à 60°C. La pression dans le réacteur peut être comprise entre 1,3 Pa (environ 10 mTorr) et 8 Pa (environ 60 mTorr). Le réacteur utilisé peut être un réacteur ICP avec une puissance de source comprise entre 1000 W et 2000 W et une puissance de polarisation comprise entre 100 W et 400 W. La durée de l'opération de gravure peut être comprise entre 100 s et 1000 s.

La hauteur H des poteaux 28 dépend de la profondeur de gravure et donc de la durée du procédé de gravure. La hauteur H peut être augmentée en augmentant la durée de l'étape de gravure. La largeur a peut être augmentée en augmentant la proportion du gaz oxydant et donc en diminuant le rapport F/O. L'écart b peut être augmenté en augmentant la proportion du gaz de gravure fluoré et donc en augmentant le rapport F/O.

La couche de silicium amorphe ou polycristallin 64 peut être recouverte d'une couche d'oxyde de silicium, appelé oxyde natif, qui se forme de façon automatique en surface du silicium en présence d'oxygène. L'étape de gravure de la couche de silicium amorphe ou polycristallin 64 peut alors être précédée par une étape de gravure de la couche d'oxyde natif. La gravure de l'oxyde natif peut être une gravure mettant en oeuvre un plasma à base d'argon ou de tétrafluorure de carbone ($CF_4$). La pression dans le réacteur peut être comprise entre 5 mTorr (environ 0,7 Pa) et 20 mTorr (2,7 Pa). Le réacteur utilisé peut être un réacteur ICP avec une puissance de source comprise entre 100 W et 300 W et une puissance de polarisation comprise entre 50 W et 400 W. La durée de l'opération de gravure peut être de quelque secondes.

Selon un autre mode de réalisation, l'étape de formation des poteaux 28 comprend le dépôt, sur la couche de silicium amorphe ou polycristallin 64, d'une couche d'un matériau poreux, par exemple de l'oxycarbure de silicium (SiOC). Le dépôt peut être un dépôt chimique en phase vapeur assisté par plasma ou PECVD (sigle anglais pour Plasma-Enhanced Chemical Vapor Déposition) réalisé par exemple à une température de 350°C suivi d'un recuit utilisant une source d'un rayonnement ultraviolet.

L'étape de dépôt de la couche du matériau poreux est suivie d'une étape de gravure de la couche du matériau poreux et de la couche de silicium amorphe ou polycristallin. La porosité de la couche du matériau poreux se traduit par des trous débouchant en surface. Lors de la gravure, le relief en surface de la couche du matériau poreux est transféré sur la couche 64 de silicium amorphe ou polycristallin ce qui entraîne la formation des poteaux 28. La gravure peut être une gravure fluorée.

Après l'étape de gravure des poteaux 28, un mode de réalisation du procédé de fabrication peut comprendre le dépôt de la couche hydrophobe 36 sur la totalité de la structure représentée en figure 9D pour obtenir la structure de poteaux 28 représentée en figure 5. De façon avantageuse, la couche hydrophobe 36 est déposée de façon conforme.

Le dépôt de la couche hydrophobe 36 peut être réalisé en plaçant la structure représentée en figure 9B dans un plasma de passivation formé à partir d'octafluorobutène ($C_3F_8$), d'héxafluoroéthane ($C_2F_6$), de tétrafluorure de carbone ($CF_4$) et/ou de trifluorométhane ($CHF_3$). La durée d'exposition de la structure représentée en figure 9D au plasma peut être comprise entre 3 et 30 secondes.

A titre d'exemple, les gaz $C_4F_8$, $C_2F_6$, $CF_4$ et/ou $CHF_3$ peuvent être introduits dans la chambre d'un réacteur. Un plasma est alors formé à température ambiante, par exemple à environ 20°C, en appliquant un courant radiofréquence adapté à la chambre. La pression dans la chambre du réacteur est, par exemple, de 10 Pa à 100 Pa. Le plasma à base

du gaz $C_4F_8$, $C_2F_6$, $CF_4$ et/ou $CHF_3$ peut être formé dans un réacteur ICP avec un générateur radiofréquence.

La figure 9E représente la structure obtenue après le retrait de la portion de résine 60 de façon à exposer la portion 66 de la face 24 qui était recouverte par la portion de résine 60. L'étape de retrait peut être réalisée en plaçant la structure obtenue à l'étape 9D dans un bain d'un solvant adapté à dissoudre la résine. La durée du traitement dans le bain est, par exemple, comprise entre 40 secondes et 1 minute. Le solvant est, par exemple, l'acétone ou le N-méthyl-2-pyrrolidone. De façon avantageuse, des ultrasons sont appliqués au support 20 pendant son immersion dans le bain. A titre d'exemple, la fréquence des ultrasons est comprise entre 45 kHz et 47 kHz.

Selon un mode de réalisation, le procédé comprend en outre un traitement entraînant une augmentation de la mouillabilité de la portion 66 exposée pour former le plot 26 à mouillabilité élevée destiné à la mise en oeuvre d'un procédé d'auto-assemblage. Le traitement comprend l'exposition de la totalité de la structure représentée en figure 9E à un rayonnement ultraviolet en présence d'ozone. Le rayonnement ultraviolet comprend un premier rayonnement ultraviolet à une première longueur d'onde comprise entre 182 nm et 187 nm, par exemple de l'ordre de 184,9 nm, et un deuxième rayonnement ultraviolet à une deuxième longueur d'onde comprise entre 250 nm et 255 nm, par exemple de l'ordre de 253,7 nm. Le premier rayonnement permet notamment d'altérer les composés hydrocarbonés présents sur la portion 66. Le deuxième rayonnement permet notamment de former des radicaux actifs à partir de l'ozone, ces radicaux actifs réagissant avec les composés hydrocarbonés pour former des composés volatils qui sont évacués. Le traitement peut être mis en oeuvre à une température de l'ordre de 80°C dans une enceinte contenant initialement de l'ozone. Ce traitement UV peut être réalisé à la pression atmosphérique.

De façon avantageuse, les plots 26 à mouillabilité élevée sont réalisés après les régions à mouillabilité faible entourant les plots 26. Le procédé de fabrication des régions à mouillabilité faible n'entraîne donc pas une réduction de la mouillabilité des plots à mouillabilité élevée. En outre, le procédé de fabrication des plots à mouillabilité élevée n'entraîne pas une augmentation de la mouillabilité des régions à mouillabilité faible déjà réalisées. Dans ce but, de façon avantageuse, les poteaux 28 comprennent en surface la couche 36 d'un matériau fluoré, de préférence fluorocarboné. En effet, les inventeurs ont mis en évidence que la couche du matériau fluoré, de préférence fluorocarboné, conserve une mouillabilité faible même après lui avoir appliqué le traitement par rayonnement ultraviolet en présence d'ozone.

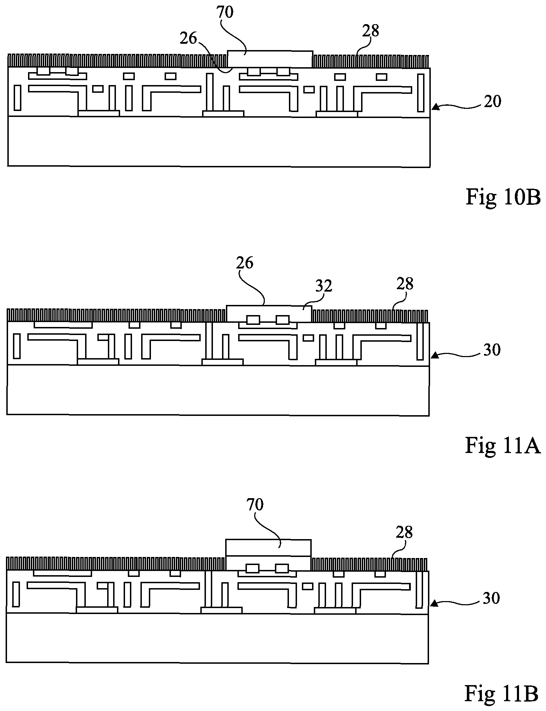

Les figures 10A et 10B sont des vues en coupe, partielles et schématiques, de structures obtenues à des étapes successives d'un mode de réalisation d'un procédé d'auto-assemblage mettant en oeuvre le support 20, par exemple tel qu'obtenu par la mise en oeuvre des étapes illustrées aux figures 9A à 9E.

La figure 10A représente la structure obtenue après le dépôt d'eau sur le support 20 qui a coalescé pour former une goutte d'eau 68 sur le plot 26 et la mise en place d'un circuit électronique 70, par exemple une puce de circuit intégré, au contact de la goutte d'eau 68. Les forces exercées par la goutte 68 sur le circuit électronique 70 déplacent alors le circuit électronique 70 jusqu'à l'alignement souhaité par rapport au plot 26. Le dépôt d'eau sur le support 20 peut être réalisé par pulvérisation.

La figure 10B représente la structure obtenue après la fixation du circuit électronique 70 au support 20. La fixation peut être réalisée par collage moléculaire ou par thermocompression.

Le procédé peut comprendre une étape ultérieure de retrait des poteaux 28. Ceci peut être réalisé par une opération de gravure avec arrêt sur la face 24.

La figure 11A est une vue en coupe, partielle et schématique, de la structure obtenue à une étape d'un mode de réalisation d'un procédé de fabrication du support représenté en figure 4. Le présent mode de réalisation du procédé de fabrication comprend l'ensemble des étapes décrites précédemment en relation avec les figures 9A à 9E, à la différence qu'il comprend une étape de formation de l'élément en saillie 32 par rapport à la face 24 qui peut être mise en oeuvre après la formation de la portion de résine 60. L'élément en saillie 32 peut être formé par une étape de gravure anisotrope, la portion de résine 60 jouant le rôle d'un masque de gravure. Il peut s'agir d'une gravure profonde par ions réactifs ou DRIE (sigle anglais pour Deep Reactive Ion Etching) . Le gaz de gravure peut être l'hexafluorure de soufre ($SF_6$). Il peut s'agir d'une gravure profonde par ions réactifs ou DRIE (sigle anglais pour Deep Reactive Ion Etching). On utilise pour cela par exemple un mélange $SF_6/O_2$ ou un procédé de type BOSCH alternant des étapes de dépôt par plasma d'un gaz polymérisant de type $C_xH_yF_z$ et des étapes de gravure par exemple avec du $SF_6$.

La figure 11B est une vue en coupe, partielle et schématique, de la structure obtenue à une étape d'un mode de réalisation d'un procédé d'auto-assemblage mettant en oeuvre le support de la figure 4. La formation du plot 26 au sommet de l'élément en saillie 32 permet de bénéficier, en plus de la différence de mouillabilité entre le plot 26 et la région 27 entourant le plot, d'un effet d'ancrage, appelé canthotaxis, de la goutte sur le sommet de l'élément en saillie 32 pour maintenir la goutte confinée sur le plot 26.

Le procédé de fabrication selon l'invention est particulièrement adapté dans le cas où la fixation du circuit électronique 70 au support 20 ou 30, qui est réalisée après l'auto-assemblage, est effectuée par collage moléculaire. En effet, pour ce type de fixation, il est nécessaire de prévoir des surfaces avec une rugosité adaptée. Les exemples de procédé de fabrication décrits précédemment permettent d'obtenir des plots 26 dont la rugosité moyenne quadratique RMS est par exemple comprise entre 0,2 nm et 0,5 nm (mesurée sur une surface de mesure de 1 $\mu m^2$), c'est-à-dire adaptée à un procédé de collage moléculaire. En outre, la portion 26 ayant une mouillabilité élevée, elle est adaptée à la réalisation d'un collage moléculaire hydrophile.

Dans les modes de réalisation décrits précédemment, la couche 64 est une couche de silicium amorphe ou polycristallin qui est gravée pour former les poteaux 28. Selon un autre mode de réalisation, la couche 64 est remplacée par une couche d'un matériau semiconducteur ou d'un autre type de matériau qui est gravée par exemple par des techniques de photolithogravure au travers d'un masque pour former les poteaux 28.

Des modes de réalisation particuliers de la présente invention ont été décrits. Diverses variantes et modifications apparaîtront à l'homme de l'art. En particulier, dans les modes de réalisation décrits précédemment, le support 20 correspond à un circuit électronique. A titre de variante, le support 20 peut être un substrat en verre ou un substrat métallique.

**Revendications**

1. Procédé d'auto-assemblage d'un élément (70) sur une face (24) d'un support (20 ; 30) comprenant les étapes suivantes :

   fournir un support (20 ; 30) comprenant au moins un plot d'assemblage (26) sur ladite face (24) ;
   déposer une goutte (40 ; 68) d'un liquide sur le plot d'assemblage (26)° ; et
   amener l'élément (70) au contact de la goutte, d'où il résulte un auto-assemblage de l'élément par rapport au support (20 ; 30),
   **caractérisé en ce que** le support comprend des poteaux (28) nanométriques ou micrométriques sur ladite face (24) autour du plot (26), chaque poteau (28) comprenant au moins un coeur (34) en silicium amorphe ou polycristallin, la goutte de liquide ayant un angle de contact statique sur le plot d'assemblage inférieur ou égal à 15°, la goutte de liquide ayant un angle de contact statique sur les poteaux supérieur ou égal à 150°.

2. Procédé selon la revendication 1, dans lequel les poteaux (28) ont une hauteur H et une largeur a mesurée dans un plan parallèle à la face (24), dans lequel des poteaux adjacents sont écartés d'un écart b mesuré dans un plan parallèle à la face (24) et dans lequel la hauteur H, la largeur a et l'écart b vérifient les relations suivantes :

$$a < \frac{b}{4}$$

$$H \geq b$$

$$b < \sqrt{\frac{\Gamma}{\rho\, g}}$$

où $\Gamma$ est égal à la tension de surface du liquide, $\rho$ est égal à la densité du liquide et g est la constante gravitationnelle.

3. Procédé selon la revendication 1 ou 2, dans lequel chaque poteau (28) comprend au moins en surface un matériau fluoré.

4. Procédé selon la revendication 3, dans lequel le matériau fluoré est un matériau fluorocarboné.

5. Procédé selon l'une quelconque des revendications 1 à 4, comprenant, en outre, une protubérance (32) comprenant des flancs (33) et un sommet, le plot d'assemblage (26) étant sur le sommet.

6. Procédé selon la revendication 5 dans son rattachement à la revendication 3, dans lequel les flancs (33) comprennent en surface le matériau fluoré.

7. Procédé selon l'une quelconque des revendications 1 à 6, dans lequel l'étape de fourniture du support (20 ; 30) comprend la formation, sur le support, des poteaux (28) nanométriques ou micrométriques autour de l'emplacement (66) du plot d'assemblage, une goutte de liquide (40 ; 68) ayant un angle de contact statique sur le plot d'assemblage inférieur ou égal à 15°, la goutte de liquide ayant un angle de contact statique sur les poteaux (28) supérieur ou égal à 150°.

8.  Procédé selon la revendication 7, comprenant le dépôt d'une couche (64) de silicium amorphe ou polycristallin sur la face (24) et la gravure de la couche de silicium amorphe ou polycristallin pour former les poteaux (28).

9.  Procédé selon la revendication 8, comprenant le dépôt d'une couche poreuse sur la couche (64) de silicium amorphe ou polycristallin.

10. Procédé selon l'une quelconque des revendications 7 à 9, dans lequel l'étape de formation des poteaux (28) comprend la formation en surface de chaque poteau d'une couche (36) d'au moins un matériau fluoré.

11. Procédé selon l'une quelconque des revendications 7 à 10, comprenant l'exposition des poteaux et de l'emplacement (66) à un traitement ultraviolet en présence d'ozone pour former le plot d'assemblage audit emplacement.

12. Procédé selon l'une quelconque des revendications 1 à 11, dans lequel l'élément (70) est une puce de circuit électronique.

13. Procédé selon l'une quelconque des revendications 1 à 12, comprenant, en outre, les étapes suivantes :

faire sécher la goutte (68) ; et
fixer l'élément (70) au support (20 ; 30).

**Patentansprüche**

1.  Ein Verfahren zur Selbstmontage eines Elements (70) auf einer Seite bzw. Oberfläche (24) eines Trägers (20; 30), das die folgenden Schritte aufweist:

Bereitstellen eines Trägers (20; 30) mit mindestens einer Montagefläche bzw. einem Montagepad (26) auf besagter Oberfläche (24); und
Aufbringen eines Tropfens (40; 68) einer Flüssigkeit auf die Montagefläche (26); und
Inkontaktbringen des Elements (70) mit dem Tropfen, was zu einer Selbstmontage des Elements in Bezug auf den Träger (20; 30) führt,
**dadurch gekennzeichnet, dass**
der Träger Säulen (28) im Nanometer- oder Mikrometerbereich auf besagter Oberfläche (24) um die Fläche (26) herum aufweist, wobei jede Säule (28) mindestens einen Kern (34) aus amorphem oder polykristallinem Silizium aufweist, wobei der Flüssigkeitstropfen einen statischen Kontaktwinkel auf der Montagefläche von kleiner oder gleich 15° hat, wobei der Flüssigkeitstropfen einen statischen Kontaktwinkel auf den Säulen von größer oder gleich 150° hat.

2.  Das Verfahren nach Anspruch 1, wobei die Säulen (28) eine Höhe H und eine Breite a, gemessen in einer Ebene parallel zu der Fläche (24), aufweisen, wobei benachbarte Säulen um einen Abstand b, gemessen in einer Ebene parallel zu der Fläche (24), beabstandet sind und wobei die Höhe H, die Breite a und der Abstand b die folgenden Bedingungen erfüllen:

$$a < \frac{b}{4}$$

$$H \geq b$$

$$b < \sqrt{\frac{\Gamma}{\rho g}}$$

wobei $\Gamma$ gleich der Oberflächenspannung der Flüssigkeit ist, wobei $\rho$ gleich der Dichte der Flüssigkeit ist und wobei g die Gravitationskonstante ist.

3.  Das Verfahren nach Anspruch 1 oder 2, wobei jede Säule (28) zumindest auf seiner Oberfläche ein fluoriertes Material aufweist.

4.  Das Verfahren nach Anspruch 3, wobei das fluorierte Material ein Fluorkohlenstoffmaterial ist.

5.  Das Verfahren nach einem der Ansprüche 1 bis 4, das ferner einen Vorsprung (32) mit Flanken (33) und einem Scheitelpunkt aufweist, wobei sich die Montagefläche (26) auf dem Scheitelpunkt befindet.

6.  Das Verfahren nach Anspruch 5 in seiner Verbindung mit Anspruch 3, wobei die Flanken (33) an bzw. auf ihrer Oberfläche das fluorierte Material aufweisen.

7.  Das Verfahren nach einem der Ansprüche 1 bis 6, wobei der Schritt des Bereitstellens des Trägers (20; 30) das Bilden von nano- oder mikrometergroßen Säulen (28) auf dem Träger um die Stelle (66) der Montagefläche herum aufweist, wobei ein Flüssigkeitstropfen (40; 68) einen statischen Kontaktwinkel auf der Montagefläche von kleiner oder gleich 15° aufweist, wobei der Flüssigkeitstropfen einen statischen Kontaktwinkel auf den Säulen (28) von größer oder gleich 150° aufweist.

8.  Das Verfahren nach Anspruch 7, das das Aufbringen einer Schicht (64) aus amorphem oder polykristallinem Silizium auf die bzw. der Fläche (24) und das Ätzen der Schicht aus amorphem oder polykristallinem Silizium aufweist, um die Säulen (28) zu bilden.

9.  Das Verfahren nach Anspruch 8, das das Aufbringen einer porösen Schicht auf die Schicht (64) aus amorphem oder polykristallinem Silizium aufweist.

10. Das Verfahren nach einem der Ansprüche 7 bis 9, wobei der Schritt der Bildung der Säulen (28) die Bildung einer Schicht (36) zumindest aus einem fluorierten Material auf der Oberfläche jeder Säule aufweist.

11. Das Verfahren nach einem der Ansprüche 7 bis 10, das das Aussetzen der Säulen und der Stelle (66) einer ultravioletten Behandlung in Gegenwart von Ozon aufweist, um die Montagefläche an der besagter Stelle zu bilden.

12. Das Verfahren nach einem der Ansprüche 1 bis 11, wobei das Element (70) ein Chip für eine elektronische Schaltung ist.

13. Das Verfahren nach einem der Ansprüche 1 bis 12, das außerdem die folgenden Schritte aufweist:

Trocknen bzw. Trocknen lassen des Tropfens (68); und
Befestigen des Elements (70) am Träger (20; 30).

**Claims**

1.  A method of self-assembly of an element (70) onto a surface (24) of a support (20; 30) comprising the steps of:

providing a support (20; 30) comprising at least one assembly pad (26) on said surface (24);
depositing a drop (40; 68) of a liquid on the assembly pad (26); and
bringing the element (70) into contact with the drop, which results in a self-assembly of the element with respect to the support (20; 30),
**characterized in that** the support comprises nanometer- or micrometer-range pillars (28) on said surface (24) around the pad (26), each pillar (28) comprising at least one amorphous silicon or polysilicon core (34), the liquid drop having a static angle of contact on the assembly pad smaller than or equal to 15°, the liquid drop having a static angle of contact on the pillars greater than or equal to 150°.

2.  The method of claim 1, wherein the pillars (28) have a height H and a width a measured in a plane parallel to the surface (24), wherein adjacent pillars are spaced apart by an interval b measured in a plane parallel to the surface (24) and wherein height H, width a, and interval b verify the following relations:

$$a < \frac{b}{4}$$

$$H \geq b$$

$$b < \sqrt{\frac{\Gamma}{\rho\,g}}$$

where $\Gamma$ is equal to the surface tension of the liquid, $\rho$ is equal to the density of the liquid, and g is the gravitational constant.

3. The method of claim 1 or 2, wherein each pillar (28) comprises at least at its surface a fluorinated material.

4. The method of claim 3, wherein the fluorinated material is a fluorocarbon material.

5. The method of any of claims 1 to 4, further comprising a protrusion (32) comprising sides (33) and a top, the assembly pad (26) being on the top.

6. The method of claim 5 and of claim 3, wherein the sides (33) comprise at their surface the fluorinated material.

7. The method of any of claims 1 to 6, wherein the step of providing the support (20; 30) comprises the forming, on the support, of nanometer- or micrometer-range pillars (28) around the location (66) of the assembly pad, a liquid drop (40; 68) having a static angle of contact on the assembly pad smaller than or equal to 15°, the liquid drop having a static angle of contact on the pillars (28) greater than or equal to 150°.

8. The method of claim 7, comprising depositing an amorphous silicon or polysilicon layer (64) on the surface (24) and etching the amorphous silicon or polysilicon layer to form the pillars (28).

9. The method of claim 8, comprising depositing a porous layer on the amorphous silicon or polysilicon layer (64).

10. The method of any of claims 7 to 9, wherein the step of forming the pillars (28) comprises forming at the surface of each pillar a layer (36) of at least one fluorinated material.

11. The method of any of claims 7 to 10, comprising exposing the pillars and the location (66) to an ultraviolet treatment in the presence of ozone to form the assembly pad at said location.

12. The method of any of claims 1 to 11, wherein the element (70) is an electronic circuit chip.

13. The method of any of claims 1 to 12, further comprising the steps of:

    drying the drop (68); and
    bonding the element (70) to the support (20; 30).

Fig 1A                    Fig 1B                    Fig 1C

Fig 2A                    Fig 2B                    Fig 2C

EP 3 535 778 B1

28    26    20

27    24

22

**Fig 3**

28    26  32  33    30

27    24

22

**Fig 4**

28  36    20

34    24

22

**Fig 5**

40

28    $\theta_c$

24    22

**Fig 6**

Fig 7

Fig 8

Fig 9A

Fig 9B

Fig 9C

Fig 9D

Fig 9E

Fig 10A

Fig 10B

Fig 11A

Fig 11B

**EP 3 535 778 B1**

## RÉFÉRENCES CITÉES DANS LA DESCRIPTION

**Documents brevets cités dans la description**

- US 2014360252 A
- WO 2016112344 A
- US 2014238645 A
- US 2015287695 A
- JP 2001087953 A